# EUROPÄISCHE PATENTSCHRIFT

(11) **EP 2 248 401 B1**
(45) Veröffentlichungstag und Bekanntmachung des Hinweises auf die Patenterteilung: **27.06.2012**
(21) Anmeldenummer: 08872793.8
(22) Anmeldetag: 10.12.2008
(51) Int. Cl.: H05K 3/04, H05K 3/32

(54) **VERFAHREN ZUR HERSTELLUNG VON LEITERPLATTEN MIT BESTÜCKTEN BAUELEMENTEN**
METHOD FOR PRODUCING PRINTED CIRCUIT BOARDS COMPRISING FITTED COMPONENTS
PROCEDE POUR PRODUIRE DES CARTES DE CIRCUITS IMPRIMES POURVUES DE COMPOSANTS EQUIPES

(30) Priorität: 26.02.2008 DE 102008011248
(43) Veröffentlichungstag der Anmeldung: 10.11.2010
(73) Patentinhaber: Maschinenfabrik Reinhausen GmbH, 93059 Regensburg (DE)
(72) Erfinder: BISGES, Michael, 93161 Sinzing (DE)
(86) Internationale Anmeldenummer: PCT/EP2008/010452
(87) Internationale Veröffentlichungsnummer: WO 2009/106114

(56) Entgegenhaltungen:
- EP-A- 0 395 411
- EP-A- 1 128 326
- WO-A-2006/057820
- DE-A1- 19 807 086
- DE-A1-102004 047 357
- US-A1- 2006 220 877
- US-B2- 7 102 520

## Beschreibung

Die Erfindung betrifft ein Verfahren zur Herstellung von Leiterplatten mit mindestens einem bestückten elektronischen Bauteil mit zwei oder mehr Kontakten, insbesondere ein Verfahren zur Herstellung von RFID-Etiketten.

Ein RFID-Etikett besteht aus einer Trägerfolie, einer Antennenstruktur und einem mit der Antenne verbundenen Chip. Die gesamte Anordnung ist auf einem Trägersubstrat vorgesehen. Ein RFID-Etikett der genannten Art ist beispielsweise aus der US 7,102,520 B2 bekannt. Dort ist eine solche Anordnung beschrieben, bei der auf einer Seite des Chips eine umlaufende, mehrlagige Antennenstruktur vorgesehen ist, die mit einem Chip in Verbindung steht. Um die Dicke der gesamten Anordnung zu reduzieren, ist der Chip in einer Vertiefung angeordnet.

Ein weiteres gattungsgemäßes RFID-Etikett ist aus der WO 2006/057820 bekannt. Auch hier ist ein Substrat vorgesehen, der die Antennenstruktur bildet und auf dem ein Chip leitend angeordnet ist.

Zur Herstellung solcher RFID-Etiketten sind bisher zahlreiche unterschiedliche Verfahren bekannt und es wird beispielhaft auf die US 2006/0220877 A1 verwiesen. Zum einen ist es bekannt, zunächst separat die Antennen herzustellen, wobei in vielen Fällen ein Siebdruck mit metallischen Pasten, Silberpasten etwa, erfolgt. Weiterhin sind hierfür Ätzprozesse bekannt, bei denen Folienlaminate (PET/Kupfer) mit einem Ätzresist bedruckt werden, anschließend die Feinstrukturen weggeätzt werden und somit das Negativ stehen bleibt. Ebenfalls zur Herstellung solcher Antennenanordnungen mögliche Sputter-Prozesse werden bislang kaum eingesetzt, da die notwendige Dicke der zu erzielenden Leiterbahnen der Antenne im Bereich von 5 bis 30 µm liegt. Diese Schichtdicken sind mit der Sputter-Technologie nicht wirtschaftlich zu erzielen.

Für die nachfolgende separate Chip-Kontaktierung sind ebenfalls verschiedene Verfahren bekannt. Beim "Pick-and-place" wird mittels optischer Erkennung die Position für den Chip auf der bereits hergestellten Antenne detektiert und der Chip positioniert und aufgesetzt. Anschließend wird der elektrische Kontakt mittels Klebe- oder Lötverfahren hergestellt. Da sich die "Pick-and-place"-Technologie für die immer kleiner werdenden Chips als zunehmend problematisch erwiesen hat, wird versucht, die Kontaktierungsflächen an diesen miniaturisierten Chips zu vergrößern. Insbesondere UHF-Chips werden von den Herstellern in Form von Straps als Rollenmaterial geliefert. Dabei sind Kontaktpads am Chip angebracht, die auch eine Rolle-zu-Rolle-Verarbeitung etwa auf Druckmaschinen erlauben.

Insgesamt sind die bekannten Verfahren zur Herstellung der eingangs genannten RFID-Chips kompliziert und weisen eine Reihe von Nachteilen auf. Ein erster Nachteil besteht darin, dass bisher die Herstellung der Antennenstruktur und die Chip-Kontaktierung als separate, nacheinander ablaufende Arbeitsschritte erfolgen.

Bei der Antennenherstellung besteht insbesondere bei den häufig verwendeten Siebdruckpasten der Nachteil, dass Lösemittel oder Polymere in den Pasten enthalten sind, was die elektrische Leitfähigkeit der aufgebrachten Antennenstruktur beeinträchtigt. Außerdem neigen derartige Antennenstrukturen oder Leiterbahnen generell zu Oxidation und Alterung.

Bei den ebenfalls häufig verwendeten Sputter-Verfahren können zwar sehr reine metallische Schichten abgeschieden werden, Schichtdicken über 1 µm, die für die Antennenstruktur erforderlich sind, können aber nur sehr aufwändig erzeugt werden.

Bei der nachfolgenden separaten Kontaktierung des elektronischen Bauteiles bzw. der elektronischen Bauteile ist die Positioniergeschwindigkeit begrenzt und eine hohe Positionierungsgenauigkeit nur mit großem technologischen Aufwand erreichbar.

Aufgabe der Erfindung ist es, die Nachteile der bekannten Technologien zu vermeiden und ein einheitliches Verfahren sowohl zur Herstellung von Leiterbahnen, d. h. leitenden geometrischen Strukturen, beispielsweise bei RFIDs der Antennenstruktur, als auch der elektrischen Verbindung des Bauteils bzw. der Bauteile mit dieser anzugeben, bei dem bei hohen Beschichtungsraten fein strukturierte, rein metallische Strukturen in der erforderlichen Schichtstärke von 1 bis 100 µm auf temperaturempfindlichen Substraten erzeugt werden können.

Diese Aufgabe wird durch ein Verfahren mit den Merkmalen des ersten Patentanspruches gelöst. Die Unteransprüche betreffen besonders vorteilhafte Weiterbildungen und Ausgestaltungen des erfindungsgemäßen Verfahrens.

Nach einem Merkmal des erfindungsgemäßen Verfahrens wird vor der Maskierung das später mit der noch herzustellenden Leiter- bzw. Antennenstruktur zu kontaktierende Bauteil auf dem Substrat fixiert. Nach einem weiteren Merkmal wird nachfolgend eine Negativmaskierung der zu erzeugenden Leiter- bzw. Antennenstruktur aufgedruckt. Die dabei verwendeten Druckfarben sind insbesondere unvernetzt, d. h. es können Öle, Wachse und kurzkettige Polymere verwendet werden. Nach einem weiteren Merkmal wird nachfolgend auf diese Negativ-Maskierung eine vollflächige Metallschicht auf der gesamten Oberfläche des Substrates mit einem Plasmabeschichtungsverfahren aufgebracht. Zur Plasmabeschichtung eignen sich besonders Plasma-Barriereentladungen, bei denen ein kaltes Plasma erzeugt wird, das die temperaturempfindliche Substratoberfläche nicht schädigt. Gleichzeitig mit der Leiter- bzw. Antennenherstellung werden beim erfindungsgemäßen Verfahren auch die Kontakte des Bauteils bzw. Chips übermetallisiert und somit angebunden.

Anschließend wird beim erfindungsgemäßen Verfahren mit einem sogenannten "Slug-Puller" die Negativ-Maske einschließlich der darauf liegenden Metallschicht abgelöst und entfernt. Dies erfolgt besonders vorteilhaft durch Peeling. Es verbleiben damit nur die Metallstrukturen, die direkt am Substrat Haftung aufgebaut haben, d. h. die Leiter- bzw. Antennenstruktur. Auf dieser Leiter- bzw. Antennenstruktur verbleibt ebenfalls das bereits fertig kontaktierte Bauteil.

In einer vorteilhaften Weiterbildung kann das Verfahren auch für die Herstellung von leitenden Strukturen auf beiden Seiten des Substrates verwendet werden, indem das Substrat gedreht wird und die entsprechenden Verfahrensschritte oder Teile davon analog wiederholt werden.

Auf besonders vorteilhafte Weise ist es beim erfindungsgemäßen Verfahren auch möglich, durch Kontaktierungen durch das Substrat hindurch, d. h. von einer Seite auf die andere, durch den Plasmastrahl, der die metallischen Bestandteile aufweist, elektrisch leitfähige Verbindungen zwischen den beiden Seiten herzustellen. Dies ist besonders bei der Herstellung von HF-RFID sinnvoll, da hier die Antenne aus einer Spule besteht, deren äußerer Kontakt mit dem inneren Kontakt wieder verbunden werden muss, um den Stromkreis zu schließen.

Insgesamt weist das erfindungsgemäße Verfahren eine Reihe von Vorteilen gegenüber dem Stand der Technik auf: Eine hohe elektrische Leitfähigkeit der Leiter- bzw. Antennenstruktur ist erzielbar; je nach Kontaktart und Substrat sind zahlreiche Metalle wie Kupfer, Aluminium, Zink, Nickel, Zinn und Legierungen davon frei wählbar. Weiterhin ermöglicht das Verfahren hohe Schichtdicken der erzeugten leitenden Strukturen, wobei auch 3-D-Konturen und Durchkontaktierungen möglich sind. Weiterhin ermöglicht das Verfahren, wie bereits weiter oben erläutert, gleichzeitig auch die Kontaktierung von Bauteilen bzw. Chips.

Insgesamt ist damit eine hohe Produktionsgeschwindigkeit bei niedrigen Kosten erreichbar.

Die Erfindung soll nachfolgend an Hand von Zeichnungen am Beispiel der Herstellung von RFID-Etiketten näher erläutert werden, sie ist jedoch nicht auf diesen Anwendungsfall beschränkt. Es zeigen:
- Figur 1: ein erfindungsgemäßes Verfahren in schematischer Darstellung der nacheinander ablaufenden einzelnen Verfahrensschritte
- Figur 2: ein Substrat, a) nach der Befestigung des Chips und b) nach der anschließenden Negativ-Maskierung
- Figur 3: wieder dieses Substrat a) beim Aufbringen der nachfolgenden Metallschicht mittels Plasmabeschichtung, b) nach dieser vollflächigen metallischen Beschichtung und c) in seitlicher Schnittdarstellung
- Figur 4: dieses Substrat a) vor der Ablösung der nicht erforderlichen Metalloberfläche, b) nach dem Ablösen mittels Slug-Puller, hier gezeigt beispielsweise als Peeling-Verfahren und c) das fertige Ergebnis, nämlich die erzeugte Antennenstruktur mit kontaktiertem Chip Figur 5 einen solchen Chip a) mit Durchkontaktierung und einer Struktur auch auf der Rückseite, b) in diagonaler Schnittdarstellung und c) ein Detail daraus
- Figur 6: ein weiteres Substrat mit einem anderen Chip mit abweichender Kontaktanordnung
- Figur 7: eine zur Plasmabeschichtung besonders geeignete Plasmavorrichtung, die mit einer dielektrisch behinderten Barrierenentladung arbeitet und ein kaltes, für das Substrat besonders schonendes Plasma erzeugt.

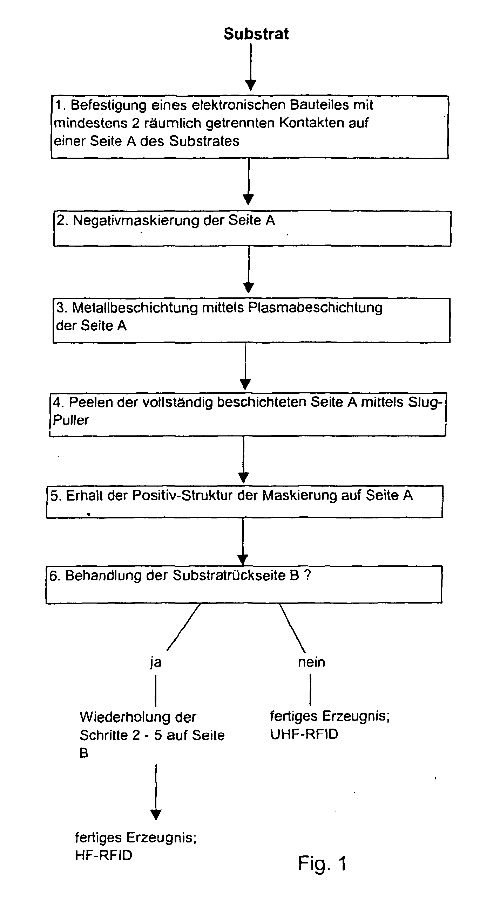

In Figur 1 ist das erfindungsgemäße Verfahren dargestellt. Es wird ausgegangen von einem Substrat, auf dem zunächst ein elektronisches Bauteil mit mindestens zwei räumlich getrennten Kontakten auf einer Seite A befestigt wird. Dies ist der bereits angesprochene Chip des RFID.

Nachfolgend wird eine Negativ-Maskierung dieser Seite vorgenommen.

Wiederum nachfolgend erfolgt eine Metallbeschichtung dieser Seite mittels Plasmabeschichtung. Anschließend wird durch einen Slug-Puller, vorzugsweise ein Haftklebeband, diese vollständig beschichtete Seite A behandelt, wobei sich die Negativ-Maske einschließend der darauf liegenden Metallschicht ablöst und entfernt wird. Dies erfolgt besonders vorteilhaft durch Peelen, wobei das Haftklebeband auf der Substratoberfläche abgerollt wird.

Im Ergebnis verbleiben nur die Metallstrukturen, die direkt am Substrat Haftung aufgebaut haben, an diesem Substrat - dies ist die Positiv-Struktur der gewünschten Antenne.

Soll auch eine Struktur auf der Substratrückseite erzeugt werden, um beispielsweise einen HF-RFID zu erzeugen, werden die Schritte von der Negativ-Maskierung bis zur Ablösung mittels Slug-Puller nach Drehen des Substrats auf dessen Rückseite wiederholt.

Es wurde bereits erläutert, dass durch das erfindungsgemäße Aufbringen der Metallschicht durch Plasmabeschichtung auch Durchkontaktierungen von der einen Seite zur anderen Seite des Substrates möglich sind.

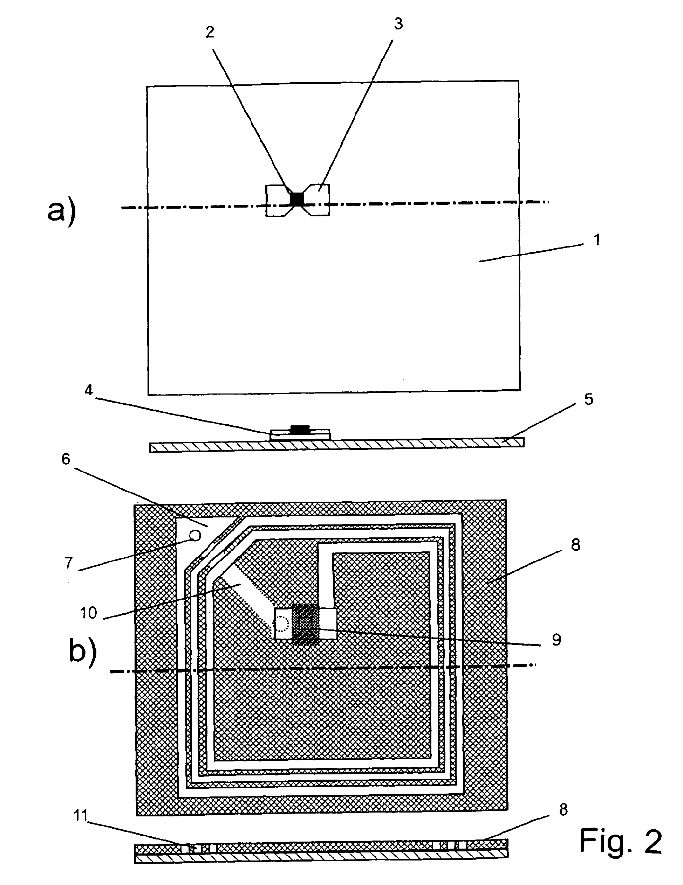

Figur 2 a) zeigt ein Substrat 1, auf dem ein RFID-Chip 2 mit Kontakt-Pads 3 befestigt ist. Die Befestigung erfolgt - dies ist in der Schnittdarstellung darunter gezeigt - durch eine Klebstoffschicht 4 auf dem Substrat 5.
Figur 2 b) zeigt diesen Chip nach der Negativ-Maskierung. Negativ-Maskierung heißt, dass die nicht bedruckte Antennenstruktur 6, die später als metallische Bahn erzeugt werden soll, frei bleibt. Hier ist eine Durchkontaktierung 7 gezeigt, die später eine elektrische Verbindung zu einem Rückseitenkontakt 10 auf der Rückseite des Chips darstellen wird. Ebenfalls gezeigt ist die bedruckte Negativ-Struktur 8 einschließlich des mitüberdruckten Chip-Bereiches 9.

Die darunter gezeigte Schnittdarstellung 2 c) zeigt noch einmal den Zusammenhang zwischen der bedruckten Negativstruktur 8 und den freien Strukturen 11.

Als Maskierungsmaterial wird Material mit einer geringen inneren Festigkeit verwendet. Dies können z. B. Öle, Wachse oder noch unvernetzte kurzkettige Polymere sein. Es eignen sich auch Maskierungsmaterialien, die spröde sind und beim Anlegen von Biegeschälkräften brechen, wie etwa getrocknete Salze.

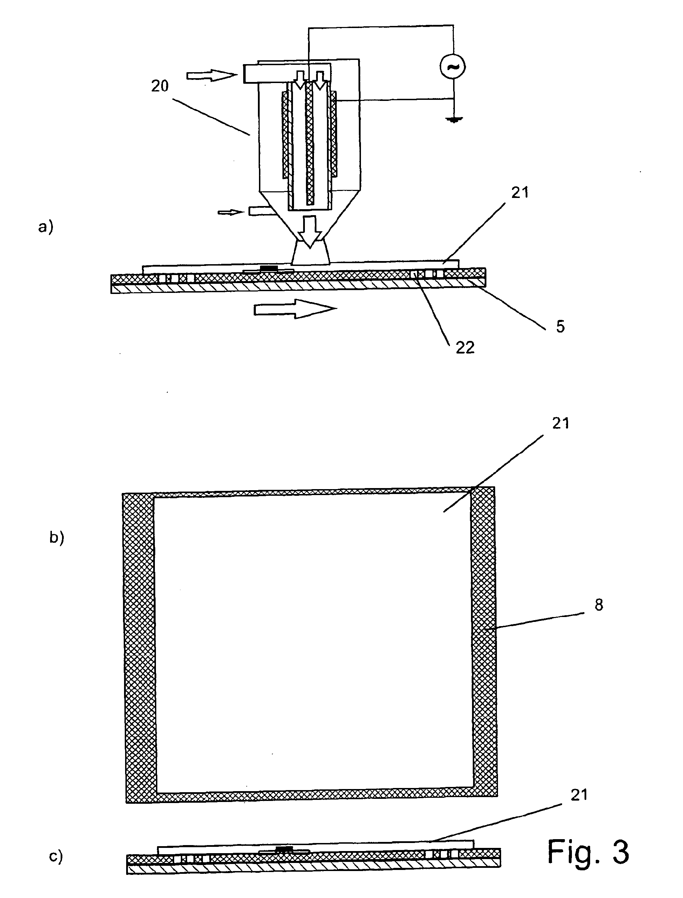

Figur 3 a) zeigt das nachfolgende Aufbringen einer vollflächigen Metallschicht auf dem Substrat 5. Es ist zu sehen, dass diese abgeschiedene Metallschicht 21 vollflächig die gesamte Oberfläche einschließlich der Struktur in der Maske 22 und auch den aufgebrachten Chip überdeckt. Auf die hier nur andeutungsweise dargestellte Plasmaeinrichtung 20 wird später noch näher eingegangen.
Figur 3 b) zeigt noch einmal von oben die vollflächig abgeschiedene Metallschicht 21 auf der bedruckten Negativ-Struktur 8.
Figur 3 c) zeigt eben dies in seitlicher Schnittdarstellung.

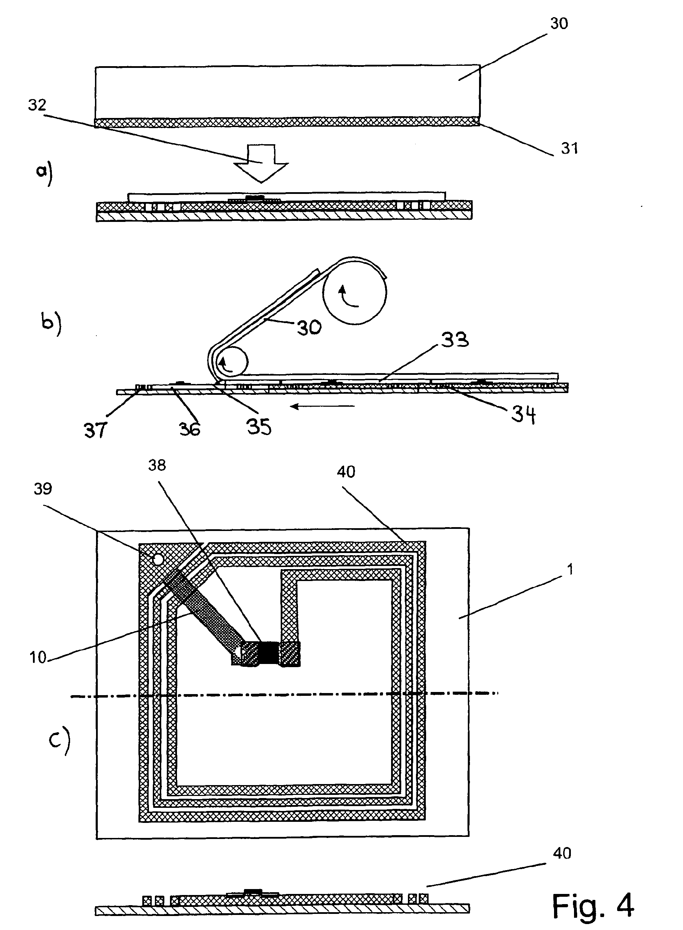

Die Haftungskräfte sind beim erfindungsgemäßen Verfahren durch geeignete Materialwahl so einzustellen, dass die Plasmabeschichtung, die unmittelbar auf dem Substrat aufgebracht ist, eine stärkere Haftung zum Substrat selbst als zum nachfolgend in Verbindung mit Figur 4 beschriebenen Slug-Puller aufweist.
Figur 4 a) zeigt das Aufbringen eines Slug-Pullers, hier Haftklebebandes 30 mit Haftklebstoff 31 in Anpressrichtung 32 auf die vollflächige metallische Beschichtung.
Figur 4 b) zeigt das Ablösen. Das Haftklebeband 30 wird über eine Andruckrolle mit einem definierten Anpressdruck und mit der Haftseite hin zum Substrat auf dieses Substrat aufgepresst. Durch die räumliche Umlenkung des Haftklebebandes entstehen Kräfte senkrecht zum Substrat, die zur partiellen Ablösung der Beschichtung führen. Da die Haftkraft des Haftklebebandes hier geringer ist als die Haftung der Beschichtung der metallischen Beschichtung direkt auf dem Substrat werden diese Bereiche der leitenden Beschichtung nicht abgelöst. Hingegen werden die Bereiche der Negativ-Maskierung am Haftklebeband gebunden, d. h. von diesem abgelöst, da, wie weiter oben erläutert, die inneren Haftungskräfte des Maskierungsmaterials geringer sind als die Haftkraft des Haftklebebandes. Es ist zu sehen, dass am Haftklebeband 30 die abgelöste Metallschicht 33 einschließlich der Hohlräume 34 in der abgelösten Maskierung verbleibt. Auf dem Substrat 5 bleibt der Chip 36 sowohl die positive, direkt am Substrat haftende Metallstruktur 37.
Figur 4 c) zeigt den fertigen, hier beidseitig behandelten, RFID-Chip: Auf einem Substrat 1 ist eine Antennenstruktur 40 metallisch ausgebildet, die eine Durchkontaktierung 39 zu einer Rückseitenbrücke 10 aufweist und auf der, nach Entfernung der Maskierung, ein Chip 38 befestigt und kontaktiert ist.

Durch die Wahl der geeigneten Materialien ist verfahrensmäßig sichergestellt, dass nur die vorher maskierten Bereiche einschließlich der darauf aufliegenden Beschichtung am Haftklebeband haften bleiben und mit diesem entfernt werden.

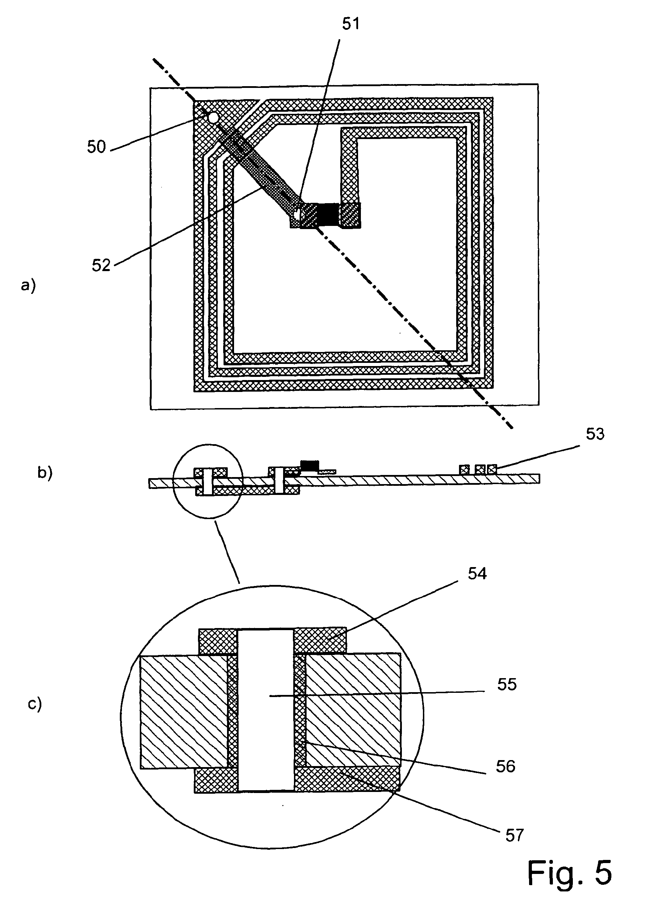

Figur 5 a) zeigt noch einmal einen solchen Chip, hier mit einer äußeren Durchkontaktierung 50 und einer inneren, rückwärtigen Durchkontaktierung 51, die mittels einer Rückseitenbrücke 52 elektrisch leitend miteinander verbunden sind.
Figur 5 b) zeigt in diagonaler Schnittdarstellung noch einmal diesen Aufbau auf beiden Seiten des Substrats sowie die Antennenstruktur 53 auf dessen Oberseite.
Figur 5 c) zeigt eine Detailerstellung auf Figur 5 b). Hier ist zu sehen, dass eine Durchkontaktierung 54 aus einem Durchgangsloch 55 besteht, das eine Innenseitenmetallisierung 56 aufweist, die durch die vorangehende Metallbeschichtung mittels Plasmabeschichtung erzeugt worden ist. Eine

Rückseitenbrücke 57 stellt die elektrisch leitende Verbindung auf der unteren Seite des Chips her. Es soll hier nicht unerwähnt bleiben, dass ein gewisser Mindestdurchmesser des Durchgangsloches 55 notwendig ist, um mit Sicherheit ein Durchkontaktieren, d. h. eine vollständige Innenseitenmetallisierung 56 zu erreichen.

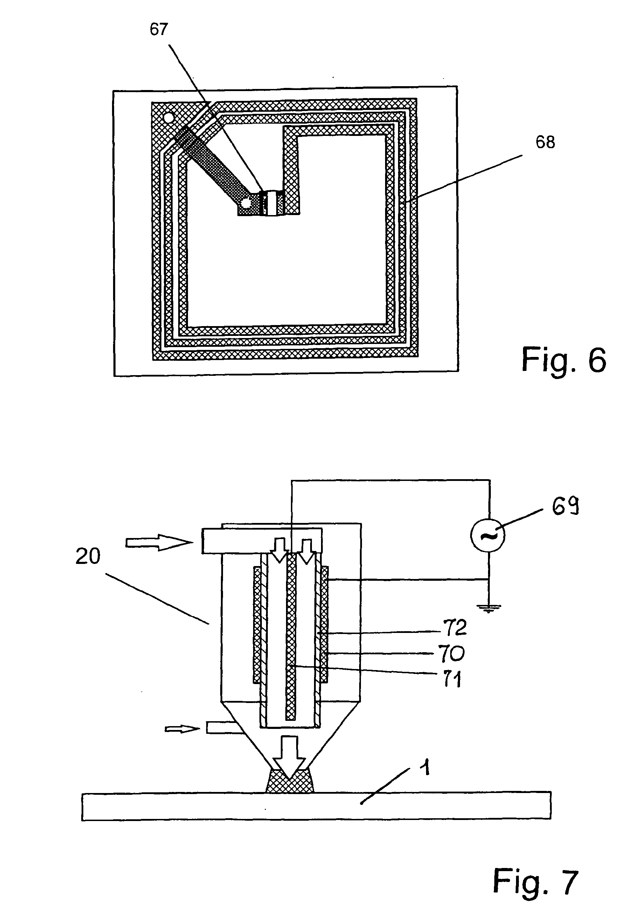

Figur 6 zeigt eine vergleichbare RFID-Anordnung, wiederum mit einer Antennenstruktur 68. Abweichend von der bisherigen Darstellung weist der Chip hier separate Kontakte auf, von denen ein Kontakt 67 gezeigt ist, der an die Antennenstruktur 68 elektrisch angebunden ist.
Figur 7 schließlich zeigt eine besonders geeignete Plasmavorrichtung 20 zur erfindungsgemäßen Metallbeschichtung nach der Negativ-Maskierung. Eine solche Plasmavorrichtung wird von der Anmelderin unter der Bezeichnung Plasmabrush® hergestellt und vertrieben. Sie weist eine äußere Elektrode 70 und eine innere, zentrale Elektrode 71 auf, die durch eine rohrförmige dielektrische Barriere 72 derart voneinander getrennt sind, dass ein konzentrischer Aufbau entsteht. Zwischen äußerer Elektrode 70 und innerer Elektrode 71 wird mittels Spannungsquelle 69 eine Wechselspannung angelegt. In der Folge wird ein homogenes, kaltes Plasma erzeugt, dem pulverförmige, leitfähige und schmelzbare Partikel zugeführt werden. Dieses Gemisch wird vollflächig auf die Substratoberfläche 1 aufgebracht und ergibt die erläuterte metallische Beschichtung im gewünschten Dickebereich.

Prinzipiell lassen sich für die Plasmabeschichtung auch andere Plasmavorrichtungen anwenden, beispielweise solche, bei denen eine direkte Bogenentladung erzeugt wird. Jedoch ist zu beachten, dass durch direkte Bogenentladung erzeugte Plasmen eine deutlich höhere Temperatur aufweisen, was bei empfindlichen Substraten problematisch sein kann.

### Bezugszeichenaufstellung

| | |
|---|---|
| 1 | substrat (Folienbahn, Folienbogen, Papier) |
| 2 | RFID-Chip |
| 3 | Kontakt-Pads |
| 4 | Klebstoffschicht |
| 5 | Substrat |
| 6 | Nicht bedruckte Antennenstruktur |
| 7 | Durchkontaktierung für Rückseitenkontakt |
| 8 | Bedruckte Negativ-Struktur |
| 9 | Überdruckter Chip-Bereich |
| 10 | Rückseitenbrücke |
| 11 | Freie Strukturbereiche |
| 20 | Erfindungsgemäße Vorrichtung Plasma-Beschichtungsanlage |
| 21 | Abgeschiedene Metallschicht |
| 22 | Abgeschiedene Metallstruktur in der Maskierung |
| 23 | |
| 30 | Haftklebeband (Slug-Puller) |
| 31 | Haftklebstoff |
| 32 | Aufpressrichtung/-kraft |
| 33 | Abgelöste Metallschicht |
| 34 | Hohlräume in der abgelösten Druckmaske |
| 35 | Auf dem Substrat anhaftende Metallstruktur |
| 36 | Chip |
| 37 | Metallstruktur |
| 38 | Chip nach Entfernung der Druckmaskierung |
| 39 | Durchkontaktierung |
| 40 | Querschnitt der Antennenstruktur |
| 50 | Durchkontaktierung außen |
| 51 | Durchkontaktierung innen |
| 52 | Rückseitenbrücke |
| 53 | Antennenstruktur Oberseite |
| 54 | Antennenstruktur mit Durchkontaktierung |
| 55 | Durchgangsloch |
| 56 | Innenseitenmetallisierung des Durchgangslochs |
| 57 | Rückseitenbrücke mit Kontaktierung zur Oberseite |
| 58 | |
| 60 | RFID-Chip |
| 61 | Kontakt 1 |
| 62 | Kontakt 2 |
| 63 | Fadenförmige Maskierung (Nylonfaden, Draht) |
| 64 | Metallisierung und Kontaktierung des Chips 1 |
| 65 | Kontakt unter der Metallisierung |
| 66 | Metallisierung und Kontaktierung des Chips 2 |
| 67 | Chip mit Anbindung zur Antenne |
| 68 | Antennenstruktur |
| 69 | Spannungsquelle |
| 70 | äußere Elektrode |
| 71 | innere Elektrode |

## Patentansprüche

1. Verfahren zur Herstellung von Leiterplatten mit mindestens einem kontaktierten Bauteil (2),
bei denen jeweils auf einem Substrat (1) eine elektrisch leitende geometrische Struktur vorgesehen ist, die mit den Kontakten (3) eines am Substrat (1) befestigten elektronischen Bauteils (2) elektrisch in Verbindung steht,
**aufweisend nachfolgende Verfahrensschritte in der folgenden Reihenfolge:**
- 1) Aufkleben des elektronischen Bauteiles (2) an seiner vorgegebenen Endposition auf einer Seite A des Substrates (1)
- 2) Negativ-Maskierung der Seite A mit einem nicht leitenden, leicht wieder entfernbaren Material (8)
- 3) vollflächige Metallbeschichtung der Seite A des Substrates (1) mittels einer Plasmabeschichtung (21)
- 4) Ablösung der Negativ-Maskierung (8) einschließlich der darauf angeordneten Metallschicht (21) mittels Slug-Puller
- 5) Freilegung der Positivstruktur (22) der Maskierung, d. h. der leitenden Struktur auf der Seite A des Substrates sowie des kontaktierten Bauteils (2) selbst.

2. Verfahren nach Anspruch 1
**dadurch gekennzeichnet,**
**dass** die Verfahrensschritte 2) bis 5) auf der Rückseite B des Substrates (1) wiederholt werden.

3. Verfahren nach Anspruch 1 oder 2,
**dadurch gekennzeichnet.**
**dass** zur Negativmaskierung (8) Öle, Wachse, kurzkettige Polymere oder andere Substanzen verwendet werden, deren Haftfestigkeit beim Peelen auf dem Substrat (1) geringer ist als die der nachfolgend aufgebrachten Metallbeschichtung (21) auf ihnen.

4. Verfahren nach Anspruch 1 bis 3,
**dadurch gekennzeichnet,**
**dass** zur Plasmabeschichtung ein kaltes, mittels dielektrisch behinderter Entladung erzeugtes Plasma verwendet wird.

5. Verfahren nach einem der Ansprüche 1 bis 4,
**dadurch gekennzeichnet,**
**dass** in das Plasma elektrisch leitendes aufschmelzbares Pulver mit Korngrößen von 100 nm bis 10 µm eingespeist wird.

6. Verfahren nach Anspruch 5,
**dadurch gekennzeichnet,**
**dass** das elektrisch leitende Pulver metallisches Pulver ist.

7. Verfahren nach Anspruch 1 bis 6,
**dadurch gekennzeichnet,**
**dass** die Entfernung mittels Slug-Puller durch Peeling erfolgt, derart, dass ein Haftklebeband oder ähnliches auf der beschichteten Oberfläche abgerollt wird.

8. Verfahren nach einem der Ansprüche 1 bis 7,
**dadurch gekennzeichnet,**
**dass** die Dicke der erzeugten elektrisch leitenden Schicht, zum Beispiel einer Antennenstruktur 0,1 bis 100 µm beträgt.

9. Verfahren nach einem der Ansprüche 1 bis 8,
**dadurch gekennzeichnet,**
**dass** das Verfahren zur Herstellung von RFID-Etiketten verwendet wird,
wobei die leitende Struktur die Antennenstruktur des RFID ergibt und das kontaktierte Bauteil der RFID-Chip ist.

## Claims

1. Method of producing circuitboards with at least one contacted component (2), in which a respective electrically conductive geometric structure is provided on a substrate (1) and is disposed in electrical connection with the contacts (3) of an electronic component (2) attached to the substrate (1), comprising the following method steps in the following sequence:
1) glueing the electronic component (2) at its predetermined final position on a side A of the substrate (1),
2) negatively masking the side A with an easily removable non-conductive material (8),
3) metal coating of the side A of the substrate (1) over the whole area by means of a plasma coating (21),
4) detaching the negative masking (8) inclusive of the metal layer (21), which is arranged thereon, by means of a slug puller and
5) freeing the positive structure (22) of the masking, i.e. the conductive structure, on the side A of the substrate as well as the contacted component (2) itself.

2. Method according to claim 1, **characterised in that** the method steps 2) to 5) are repeated on the rear side B of the substrate (1).

3. Method according to claim 1 or 2, **characterised in that** for the negative masking (8) use is made of oils, waxes, short-chain polymers or other substances, the adhesion of which, during peeling, to the substrate (1) is less than that of the subsequently applied metal coating (21) thereon.

4. Method according to any one of claims 1 to 3, **characterised in that** a cold plasma generated by means of dielectrically impeded discharge is used for the plasma coating.

5. Method according to any one of claims 1 to 4, **characterised in that** electrically conductive meltable powder with grain sizes of 100 nanometres to 10 microns is fed into the plasma.

6. Method according to claim 5, **characterised in that** the electrically conductive powder is metallic powder.

7. Method according to any one of claims 1 to 6, **characterised in that** the removal by means of slug puller is carried out by peeling in such a manner that an adhesive strip or the like is rolled off the coated surface.

8. Method according to any one of claims 1 to 7, **characterised in that** the thickness of the electrically conductive layer which is produced of, for example, an antenna structure is 0.1 to 100 microns.

9. Method according to any one of claims 1 to 8, **characterised in that** the method is employed for the production of RFID labels, wherein the conductive structure yields the antenna structure of the RFID and the contacted component is the RFID chip.

## Revendications

1. Procédé d'obtention de cartes de circuits imprimés comportant au moins un composant de contact (2) selon lequel il est respectivement prévu sur un substrat (1) une structure géométrique électriquement conductrice qui est électriquement reliée aux contacts (3) d'un composant électronique (2) fixé sur le substrat (1),
comprenant les étapes susmentionnées dans l'ordre ci-dessous :
1) collage du composant électronique (2) dans sa position finale prédéfinie sur une face A du substrat (1),
2) application sur la face A d'un masque négatif en un matériau non conducteur (8) pouvant ensuite être facilement éliminé,
3) application d'un revêtement métallique sur la totalité de la surface de la face A du substrat (1) par revêtement au plasma (21),
4) séparation du masque négatif (8) y compris de la couche métallique (21) appliquée sur ce masque par Slug-Puller,
5) dégagement de la structure positive (22) du masque, c'est-à-dire de la structure conductrice sur la face A du substrat ainsi que du composant de contact (2) lui-même.

2. Procédé conforme à la revendication 1,
**caractérisé en ce qu'**
on réitère les étapes 2) à 5) sur la face arrière B du substrat (1).

3. Procédé conforme à la revendication 1 ou 2,
**caractérisé en ce que**
pour appliquer le masque négatif (8) on utilise des huiles, des cires, des polymères à chaîne courte ou d'autres substances dont la force d'adhérence sur le substrat (1) lors d'un pelage est plus faible que celle du revêtement métallique (21) appliqué ultérieurement sur ce masque.

4. Procédé conforme à l'une des revendications 1 à 3,
**caractérisé en ce que**
pour le revêtement au plasma, on utilise un plasma froid produit par une décharge entravée par un diélectrique.

5. Procédé conforme à l'une des revendications 1 à 4,
**caractérisé en ce que**
on injecte dans le plasma, une poudre fusible électriquement conductrice ayant une granulométrie de 100 nm à 10 µm.

6. Procédé conforme à la revendication 5,
**caractérisé en ce que**
la couche électriquement conductrice est une poudre métallique.

7. Procédé conforme à l'une des revendications 1 à 6,
**caractérisé en ce que**
l'élimination s'effectue par pelage par Slug-Puller en déroulant une bande adhésive ou similaire sur la surface revêtue.

8. Procédé conforme à l'une des revendications 1 à 7,
**caractérisé en ce que**
l'épaisseur de la couche électriquement conductrice produite, par exemple une structure d'antenne est de 0,1 à 100 µm.

9. Procédé conforme à l'une des revendications 1 à 8,
**caractérisé en ce que**
le procédé est utilisé pour l'obtention d'étiquettes RFID, la structure conductrice donnant la structure d'antenne du RFID et le composant de contact étant la puce RFID.
